(19) **Europäisches Patentamt European Patent Office Office européen des brevets**

(11) **EP 4 242 668 B1**

(12) **FASCICULE DE BREVET EUROPEEN**

(45) Date de publication et mention
de la délivrance du brevet:
**21.01.2026 Bulletin 2026/04**

(21) Numéro de dépôt: **23154584.9**

(22) Date de dépôt: **02.02.2023**

(51) Classification Internationale des Brevets (IPC):
**G01R 15/06** (2006.01)   **G01R 15/16** (2006.01)

(52) Classification Coopérative des Brevets (CPC):
**G01R 15/06; G01R 15/16**

(54) **DISPOSITIF POUR LA MESURE SANS CONTACT DE TENSION**

VORRICHTUNG ZUR BERÜHRUNGSLOSEN SPANNUNGSMESSUNG

DEVICE FOR CONTACTLESS VOLTAGE MEASUREMENT

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité: **02.02.2022 FR 2200911**

(43) Date de publication de la demande:
**13.09.2023 Bulletin 2023/37**

(73) Titulaires:
• **SNCF Réseau
93200 Saint-Denis (FR)**
• **Kapteos
73800 Sainte-Hélène-du-Lac (FR)**

(72) Inventeurs:
• **DUMONT, Erwan
92700 COLOMBES (FR)**
• **DUVILLARET, Lionel
73000 CHAMBERY (FR)**
• **HENRY, Vincent
77270 VILLEPARISIS (FR)**

(74) Mandataire: **IPAZ
Bâtiment Platon
Parc Les Algorithmes
91190 Saint-Aubin (FR)**

(56) Documents cités:
**EP-A1- 3 321 696   FR-A1- 3 110 704**

EP 4 242 668 B1

**Description**

**Domaine technique**

La présente invention concerne un dispositif pour la mesure sans contact d'une tension d'un câble.

Le domaine de l'invention est celui de la mesure de tension sans contact. L'invention peut notamment être appliquée dans le domaine ferroviaire, par exemple pour la mesure sans contact de tension de caténaire agencée pour alimenter un véhicule ferroviaire.

**État de la technique**

On connaît des dispositifs de mesure de tension sans contact de câble isolé. Toutefois ces dispositifs soulèvent plusieurs problèmes, qui peuvent être :

- d'utilisation et d'adaptabilité car ces dispositifs ne peuvent mesurer que des tensions sur des câbles isolés (i.e. comprenant une forte isolation galvanique). En outre, ces dispositifs ne sont pas adaptables à toutes les gammes de tension, notamment ils ne peuvent être utilisés pour des mesures sans contact de câble à haute tension,
- de simplicité d'utilisation car les dispositifs connus nécessitent de positionner le câble isolé au milieu du dispositif, ce qui peut être contraignant, et
- d'encombrement car les dispositifs de l'état de l'art nécessitent plusieurs capteurs de tension. Les dispositifs de mesure de tension sans contact sont ainsi volumineux.

Un but de la présente invention est de remédier à au moins un des inconvénients précités.

Un autre but de la présente invention est de proposer un dispositif pour la mesure sans contact de tension de tout type de câble, qu'il soit isolé ou non isolé.

Un but de la présente invention est de proposer un dispositif pour la mesure sans contact de tension d'un câble mesurant toute gamme de tension, notamment les hautes tensions.

Un autre but de la présente invention est de proposer un dispositif pour la mesure sans contact de tension d'un câble plus facilement utilisable.

Un autre but de la présente invention est de proposer un dispositif pour la mesure sans contact de tension d'un câble comprenant un encombrement réduit.

EP 3 321 696 A1 et FR 3 110 704 A décrivent des dispositifs de mesure de tension pour lignes électriques, comprenant une enveloppe et un diviseur capacitif.

**Exposé de l'invention**

L'invention permet d'atteindre au moins un des buts précités par un système selon la revendication 1.

Ainsi le système selon l'invention comprend un seul moyen de mesure de tension. Le système selon l'invention est donc moins volumineux.

En outre, le système selon l'invention peut réaliser une mesure de tension sans contact sur tout type de câble, qu'il soit isolé ou non. Le système selon l'invention peut aussi mesurer toute gamme de tension, basse et haute tension. Par conséquent, le système selon l'invention est plus universel.

Le système selon l'invention n'est pas soumis à des contraintes de centrage du câble sur lequel la mesure est réalisée. Par conséquent, système est plus simple à utiliser.

Le potentiel de référence peut être nul, de préférence le potentiel de référence est celui de la terre.

Le moyen de mesure peut comprendre un condensateur et un capteur de tension agencé pour mesurer une tension aux bornes du condensateur.

Le moyen de mesure peut ainsi comprendre seulement deux composants. En outre, un seul moyen de mesure est nécessaire pour la mesure de tension sans contact. L'encombrement réduit du système selon l'invention est donc amélioré.

Selon un avantage, le condensateur du moyen de mesure peut être agencé pour abaisser une tension sur l'électrode principale vis-à-vis de la tension de la caténaire. Un tel agencement permet d'abaisser des hautes tensions en des tensions compatibles avec des composants standards.

Avantageusement, le capteur de tension peut comprendre une haute impédance et une faible capacité. A titre d'exemple non limitatif, le capteur de tension du moyen de mesure peut comprendre ou consister en un amplificateur suiveur à effet de champ (FET) et d'un convertisseur analogique numérique.

De préférence, le condensateur et le capteur de tension peuvent être connectés à l'électrode principale via un point de connexion, appelé premier point de connexion.

De préférence, le condensateur et le capteur de tension peuvent être connectés à l'enveloppe via un point de connexion, appelé deuxième point de connexion.

L'enveloppe peut consister en ou comprendre un carter, une enveloppe rigide.

Notamment, l'enveloppe permet de protéger les composants dudit dispositif, par exemple d'éviter la formation de couplage parasite avec des éléments extérieurs audit dispositif. L'enveloppe permet ainsi d'améliorer la précision des mesures.

L'électrode principale peut être couplée de manière capacitive audit câble et le dispositif peut être dénué de contact galvanique avec ledit câble.

Le système selon l'invention est dénué de contact physique avec la caténaire sur laquelle lamesure est réalisée. Le système selon l'invention est donc sécurisé.

En outre, le couplage capacitif permet de créer une capacité entre la caténaire et l'électrode principale. Cette capacité peut intervenir dans les mesures de tension sans contact.

La caténaire peut s'étendre suivant une direction d'élongation, l'électrode principale pouvant comprendre un axe d'élongation parallèle à la direction d'élongation de ladite caténaire.

Un tel agencement permet de favoriser le couplage capacitif entre la caténaire et l'électrode principale. La capacité créée entre le câble et l'électrode principale est donc maximisée.

L'électrode principale peut comprendre un pourtour positionné à une distance d non nulle de ladite enveloppe.

Ainsi l'électrode principale n'a pas de contact physique direct avec l'enveloppe. Un tel agencement permet d'améliorer la mesure de tension sans contact de la caténaire.

Le système selon l'invention peut comprendre une distance minimale entre le pourtour de la première électrode et l'enveloppe.

La distance d peut être choisie pour qu'un champ électrique entre l'enveloppe et le pourtour de l'électrode principale est inférieur ou égal à 3MV/m dans des conditions standards d'utilisation.

Le système peut comprendre une unité de traitement agencée et/ou programmée pour mesurer la tension de ladite caténaire à partir de la mesure de tension du moyen de mesure, d'une capacité crée par l'électrode principale et ledit câble et d'une capacité issue du moyen de mesure.

La tension de ladite caténaire mesurée par l'unité de traitement peut être déterminée par la formule suivante :

$$V_X(t) = V_M(t).\left(\frac{C_D+C_X}{C_X}\right) \text{ (Math 1)}$$

avec

- $V_X(t)$ étant la tension au cours du temps dudit câble à déterminer,
- $V_M(t)$ étant la tension mesurée par le moyen de mesure cours du temps,
- $C_D$ étant la capacité du moyen de mesure,
- $C_X$ étant la capacité créée par ledit câble et l'électrode principale.

Selon un avantage, le système selon l'invention se comporte selon un diviseur de tension capacitif. Un tel agencement facilite les mesures de haute tension.

De préférence, le système peut comprendre une autre électrode, appelée électrode secondaire, positionnée au regard de l'électrode principale.

Avantageusement, l'électrode secondaire peut être couplée de manière capacitive avec l'électrode principale. L'électrode principale combinée avec l'électrode secondaire peuvent ainsi créer une capacité.

Le dispositif de mesure de la tension est agencé pour favoriser volontairement la création de couplage capacitif entre les composants dudit dispositif. Cela permet d'éviter l'ajout de composants supplémentaires tels que des condensateurs supplémentaires. Un tel agencement permet ainsi d'optimiser le dispositif en optimisant sa compacité

De manière non limitative, l'électrode secondaire peut comprendre une bande de cuivre.

L'électrode secondaire peut être en outre positionnée au regard du moyen de mesure.

De préférence, l'électrode secondaire peut être positionnée entre électrode principale et le moyen de mesure.

L'électrode secondaire peut comprendre un axe d'élongation parallèle à la l'électrode principale. L'électrode principale et l'électrode secondaire forment ainsi un condensateur. Un tel agencement permet de maximiser la capacité créée par l'électrode principale et l'électrode secondaire.

De préférence, l'électrode secondaire, l'électrode principale et la caténaire peuvent être agencés en parallèle. Ainsi, suivant cet agencement deux capacités sont créées, une entre la caténaire et l'électrode principale et une entre l'électrode principale et secondaire.

L'électrode secondaire peut être inférieure en taille à l'électrode principale. Cela permet ainsi d'optimiser encore plus le volume du système selon l'invention.

Par exemple, chaque électrode peut comprendre un axe d'élongation principal, l'axe d'élongation principal de la deuxième électrode peut être inférieur à l'axe d'élongation principal de la première électrode.

Le dispositif peut comprendre un commutateur électrique agencé pour :

- connecter, dans une première position, le moyen de mesure à l'électrode principale, de préférence connecter le condensateur à l'électrode principale, et
- connecter, dans une deuxième position, le moyen de mesure à l'électrode secondaire, de préférence connecter le condensateur à l'électrode secondaire.

Connecter alternativement le commutateur électrique à l'électrode principale et secondaire permet d'obtenir une mise en série du condensateur créé entre l'électrode principale et secondaire et le condensateur créé entre la caténaire et l'électrode principale. Ainsi, seule la capacité créée entre l'électrode principale et l'électrode secondaire a besoin d'être connue. La facilité de la mesure de tension est ainsi améliorée car cela évite des mesures d'étalonnage pour déterminer les différentes capacités créées dans le système selon l'invention.

Le commutateur peut être positionné au niveau du premier point de connexion.

Lorsque le dispositif mesure comprend une unité de traitement, alors l'unité de traitement peut être en outre agencée et/ou programmée pour mesurer la tension de ladite caténaire en fonction d'une capacité créée par l'électrode principale et l'électrode secondaire.

Avantageusement, le dispositif utilise un seul diviseur de tension capacitif, qu'il comprenne une ou aucune électrode secondaire. Cela favorise la stabilité de la mesure et les erreurs qui peuvent découler de l'utilisation de plusieurs diviseurs capacitifs. En outre, le dispositif comprend aussi un agencement simplifié avec moins de composant, ce qui améliore la compacité dudit dispositif.

La tension de ladite caténaire mesurée par l'unité de traitement peut être déterminée par la formule suivante :

$$V_X(t) = \frac{\left(\frac{C_D}{C_I}\right).V_{M1}(t)}{\left(\left(\frac{V_{M1}(t)}{V_{M2}(t)}\right)-1\right)} \text{ (Math 2)}$$

avec

- $V_x(t)$ la tension au cours du temps de ladite caténaire à déterminer,
- $V_{M1}(t)$ la tension mesurée par le moyen de mesure lorsque le commutateur est dans la première position,
- $V_{M2}(t)$ la tension mesurée par le moyen de mesure lorsque le commutateur est dans la deuxième position,
- $C_D$ étant la capacité du moyen de mesure, et
- $C_I$ étant la capacité créée par l'électrode principale et secondaire.

Lorsque le commutateur est dans la première position, la tension mesurée par le moyen de mesure est définie par la formule suivante :

$$V_{M1}(t) = V_X(t) . \left(\frac{C_X}{(C_D+C_X)}\right) \text{ (Math 3)}$$

et

lorsque le commutateur est dans la deuxième position, la tension mesurée par le moyen de mesure est définie par la formule suivante :

$$V_{M2}(t) = V_X(t) . \left(\frac{C_{eq}}{(C_{eq}+C_D)}\right) \text{ (Math 4)}$$

avec

- $V_x(t)$ la tension au cours du temps de ladite caténaire à déterminer,
- $C_D$ la capacité du moyen de mesure,
- $Cx$ la capacité créée par la caténaire et l'électrode principale,
- $C_I$ la capacité créée par l'électrode principale et secondaire, et
- $C_{eq}$ une capacité équivalente suite une mise en série de la capacité créée par l'électrode principale et secondaire et de la capacité créée par la caténaire et l'électrode principale.

La capacité équivalente mesurée par l'unité de traitement peut être déterminée par la formule :

$$C_{eq} = \frac{c_X \cdot c_I}{(c_X + c_I)} \text{ (Math 5)}$$

avec

- $C_X$ la capacité créée par la caténaire et l'électrode principale, et
- $C_I$ la capacité créée par l'électrode principale et secondaire.

Avantageusement, la caténaire peut être parcouru par un courant alternatif.

Ainsi le système selon l'invention peut être utilisé pour réaliser des mesures sans contact de caténaire. système améliore ainsi la mesure de tension sur des caténaires car suivant l'invention, la mesure est réalisée sans contact (i.e. sans connexion galvanique). Par conséquent, le système procure une mesure de tension sécurisée.

En outre, le mesure de tension avec un tel système ne nécessite pas l'intervention d'un opérateur, par exemple pour couper l'alimentation d'une caténaire. La sécurité, la facilité d'utilisation et le temps de mesure sont ainsi améliorés.

Selon un autre aspect de l'invention, il est proposé un système pour la mesure sans contact de tension d'au moins deux caténaires d'une double voies ferrées, ledit système comprenant au moins deux dispositifs selon l'invention, chaque dispositif selon l'invention étant positionné sur un poteau relié à la terre, chaque dispositif selon l'invention étant à une position non nulle du sol, chaque poteau étant positionné le long d'une des voies ferrées, de préférence le long d'une des lames d'une desdites voies ferrées.

Le dispositif dans le système selon l'invention peut être agencé sur le poteau de manière mobile.

Un tel agencement permet de simplifier les formules pour déterminer la tension d'un ou plusieurs câbles.

Le dispositif peut comprendre 1 degré de liberté, ou 2 degrés de liberté, ou trois degrés de liberté.

Selon un autre aspect de l'invention, il est proposé une voie ferrée comportant au moins un système selon l'invention pour mesurer la tension d'au moins une caténaire.

Suivant des modes de réalisation, la voie ferrée selon l'invention peut comprendre :

- deux voies adjacentes, à savoir une voie de gauche et une voie de droite, chaque voie comprenant une caténaire, et pour chacune desdites voies, un dispositif pour mesurer une tension de la caténaire de ladite voie ;

Dans ce cas :

- le moyen de mesure du dispositif de la voie de gauche peut être agencé pour mesurer une tension $V_{MG}(t)$ définie par la formule suivante :

$$V_{MG}(t) = \alpha_G \, V_{CG}(t) + \beta_G \, V_{CD}(t) \text{ (Math 6)}$$

- le moyen de mesure du dispositif de la voie de droite peut être agencé pour mesurer une tension $V_{MD}(t)$ définie par la formule suivante :

$$V_{MD}(t) = \alpha_D \, V_{CD}(t) + \beta_D \, V_{CG}(t) \text{ (Math 7)}$$

avec

- $V_{CG}(t)$ correspondant à la tension inconnue de la caténaire positionnée sur la voie de gauche,
- $V_{CD}(t)$ correspondant à la tension inconnue de la caténaire 501 positionnée sur la voie de droite, et
- $\alpha_G, \alpha_D, \beta_G$ et $\beta_D$ correspondant à des paramètres de la relation linéaire reliant les tensions mesurées $V_{MG}(t)$ et $V_{MD}(t)$ aux tensions inconnues des caténaires gauche $V_{CG}(t)$ et droite $V_{CD}(t)$.

**Brève description des dessins**

D'autres avantages et particularités de l'invention apparaîtront à la lecture de la description détaillée de mises en œuvre et de modes de réalisation nullement limitatifs, et des dessins annexés suivants.

- la FIGURE 1 est une représentation schématique d'un premier exemple de réalisation non limitatif d'un dispositif de mesure d'une tension ;
- la FIGURE 2 une représentation schématique d'un deuxième exemple de réalisation non limitatif d'un dispositif de mesure d'une tension ;
- la FIGURE 3 une représentation schématique d'un troisième exemple de réalisation non limitatif d'un dispositif de mesure d'une tension ;
- la FIGURE 4A est une représentation schématique d'un quatrième exemple de réalisation non limitatif d'un dispositif de mesure d'une tension dans lequel un commutateur est dans une première position :
- la FIGURE 4B est une représentation schématique du quatrième exemple de réalisation non limitatif du dispositif selon l'invention dans lequel le commutateur est dans une deuxième position ;
- la FIGURE 5 est un représentation schématique d'un premier exemple d'une voie ferrée équipée d'un système selon l'invention ; et
- la FIGURE 6 est un représentation schématique d'un deuxième exemple d'une voie ferrée double voies équipée d'un système selon l'invention.

## Description détaillée des figures

Il est bien entendu que les modes de réalisation qui seront décrits dans la suite ne sont nullement limitatifs. On pourra notamment imaginer des variantes de l'invention ne comprenant qu'une sélection de caractéristiques décrites par la suite isolées des autres caractéristiques décrites, si cette sélection de caractéristiques est suffisante pour conférer un avantage technique ou pour différencier l'invention par rapport à l'état de la technique antérieure. Cette sélection comprend au moins une caractéristique de préférence fonctionnelle sans détail structurel, ou avec seulement une partie des détails structurels si cette partie uniquement est suffisante pour conférer un avantage technique ou pour différencier l'invention par rapport à l'état de la technique antérieure.

En particulier toutes les variantes et tous les modes de réalisation décrits sont combinables entre eux si rien ne s'oppose à cette combinaison sur le plan technique.

Sur les figures, les éléments communs à plusieurs figures conservent la même référence.

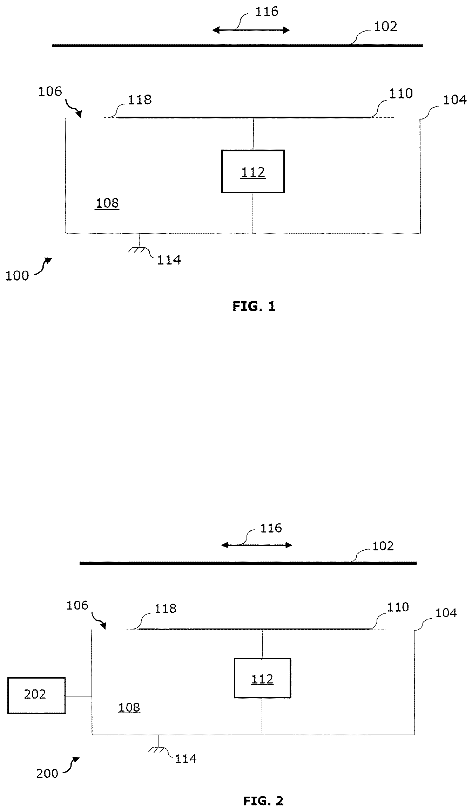

La FIGURE 1 est une représentation schématique d'un exemple de réalisation non limitatif d'un dispositif 100.

Le dispositif 100 est un dispositif pour la mesure sans contact d'une tension d'un câble 102 définie par rapport à un potentiel de référence.

Le dispositif 100 comprend une enveloppe 104 connectée au potentiel de référence. Le potentiel de référence est de préférence celui de la terre.

L'enveloppe 104 comprend une ouverture 106 orientée vers ledit câble 102, un volume intérieur 108. Le volume intérieur 108 de l'enveloppe 104 comprend :

- une électrode 110, appelée électrode principale 110, positionnée au niveau de l'ouverture 106 et au regard dudit câble 102, et
- un moyen de mesure 112 agencé pour mesurer une tension entre l'électrode principale 110 et ladite enveloppe 104. La tension mesurée par le moyen de mesure 112 est notée $V_M(t)$.

De manière non limitative, l'électrode principale 110 comprend une face libre orientée vers le câble 102, notamment face au câble 102.

Dans cet exemple, l'enveloppe 104 est connectée à la terre 114. Le potentiel de référence peut ainsi être nul. Le moyen de mesure 112 peut comprendre une capacité interne notée $C_D$.

L'enveloppe 104 peut consister en ou comprendre un carter 104. L'enveloppe 104 est de préférence une enveloppe 104 rigide.

De préférence, l'électrode principale est couplée de manière capacitive au câble 102. Ainsi, une capacité notée Cx peut être créée entre le câble 102 et l'électrode principale 110. Le dispositif 100 est dénué de contact galvanique avec le câble 102.

De manière non limitative, l'électrode principale illustrée en FIGURE 1 est de forme allongée. Suivant cet exemple non limitatif, le câble 102 s'étend suivant une direction d'élongation 116. L'électrode principale 110 comprend un axe d'élongation 118 parallèle à la direction d'élongation 116 du câble 102. De préférence, la face libre de l'électrode principale 110 positionnée face au câble 102 est parallèle à la direction d'élongation 118 dudit câble 102.

Dans cet exemple non limitatif, l'électrode principale 110 comprend un pourtour positionné à une distance d non nulle de l'enveloppe 104. Le pourtour de l'électrode principale 110 est ainsi dénué de contact direct avec l'enveloppe 104.

De manière non limitative, le dispositif 100 peut être connecté à une unité de traitement (non illustrée), externe audit dispositif 100, et agencée et/ou programmée pour mesurer la tension du câble 102 définie par rapport au potentiel de référence 114 qui est la terre. Cette unité de traitement externe au dispositif 100 peut déterminer la tension du câble 102 suivant la formule Math 1.

Dans un exemple non limitatif, le câble 102 peut être parcouru par un courant alternatif.

La FIGURE 2 est une représentation schématique d'un exemple de réalisation non limitatif d'un dispositif 200 .

Le dispositif 200 illustré en FIGURE 2 comprend tous les éléments du dispositif 100 illustré en FIGURE 1. Seules les différences avec la FIGURE 1 seront décrites.

Dans cet exemple, le dispositif 200 comprend une unité de traitement 202. L'unité de traitement 202 est agencée et/ou programmée pour mesurer la tension dudit câble 102 à partir de la mesure de tension du moyen de mesure 112, de la capacité Cx créée par l'électrode principale 110 et ledit câble 102 et de la capacité $C_D$ du moyen de mesure 112. L'unité de traitement 202 est connectée à l'enveloppe 104. L'unité de traitement 202 peut déterminer la tension du câble 102 suivant la formule Math 1.

L'unité de traitement 202 peut être positionnée à distance de l'enveloppe, par exemple dans un local de contrôle. Dans une autre variante, l'unité de traitement 202 peut être positionnée dans le volume intérieur 108 de l'enveloppe 104.

L'unité de traitement 202 peut être un microprocesseur, un ordinateur, une puce, un module de calcul.

Suivant cet exemple, la tension du câble 102 mesurée par l'unité de traitement 202 est déterminée par la formule Math 1 et est notée $V_x(t)$. Le dispositif 200 se comporte ainsi comme un diviseur de tension capacitif formé par la capacité inconnue $C_x$ et la capacité $C_d$ entre le câble 102 porté à une tension $V_x$ et l'enveloppe 104 reliée à la terre.

Si le câble 102 a une position stable par rapport au dispositif 200 alors la valeur de la capacité $C_x$ ne dépend pas du temps et se comporte ainsi comme une constante. Si une mesure de la tension relative de la tension inconnue $V_x(t)$ est suffisante, comme par exemple pour mesurer des taux de distorsion harmonique ou la présence de transitoire de type choc de manœuvre ou de foudre, alors la détermination de la capacité $C_x$ n'est pas nécessaire.

En cas de mesure de tension absolue, un étalonnage peut être réalisé à l'installation du dispositif en mesurant simultanément la tension du câble 102 $V_x(t)$ par un moyen quelconque, par exemple en réalisant un piquage de tension direct sur le câble 102, et la tension délivrée par le dispositif 200 permet de déterminer la valeur de la capacité $C_x$.

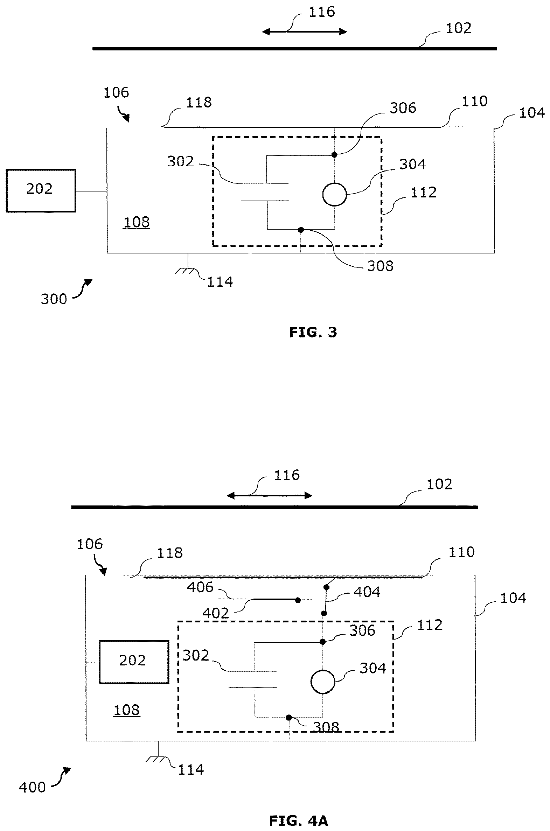

La FIGURE 3 est une représentation schématique d'un exemple de réalisation non limitatif d'un dispositif 300.

Le dispositif 300 illustré en FIGURE 3 comprend tous les éléments du dispositif 200 illustré en FIGURE 2.

Le moyen de mesure 112 du dispositif 300 comprend un condensateur 302 et un capteur de tension 304 agencé pour mesurer une tension aux bornes du condensateur 302 notée $V_M(t)$. Le condensateur 302 comprend une valeur de capacité $C_d$.

Dans cet exemple, le condensateur 302 et le capteur de tension 304 sont connectés à l'électrode principale 110 via un point de connexion 306, appelé premier point de connexion 306. Le condensateur 302 et le capteur de tension 304 sont connectés à l'enveloppe 104 via un point de connexion 308, appelé deuxième point de connexion 308.

Comme précédemment, la mesure de la tension du câble 102 est obtenue par la formule Math 1.

La FIGURE 4A est une première représentation schématique d'un exemple de réalisation non limitatif d'un dispositif 400.

Le dispositif 400 illustré en FIGURE 4A comprend tous les éléments du dispositif 300 illustré en FIGURE 3.

Le dispositif 400 illustré en FIGURE 4A comprend une autre électrode 402, appelée électrode secondaire 402 et un commutateur électrique 404.

L'électrode secondaire 402 est positionnée au regard de l'électrode principale 110. L'électrode secondaire 402 est positionnée au regard du moyen de mesure 112. Ainsi, l'électrode principale 110 est positionnée entre le câble 102 et l'électrode secondaire 402. L'électrode secondaire 402 est agencée dans le volume intérieur 108 de l'enveloppe 104. Dans cet exemple, l'électrode secondaire 402 n'est pas au contact de l'électrode principale 110. En particulier, de l'air sépare l'électrode principale 110 de l'électrode secondaire 402.

Dans cet exemple, l'électrode secondaire 402 est de forme allongée. En particulier, l'électrode secondaire 402 comprend un axe d'élongation 406 parallèle à l'électrode principale 110. L'électrode principale 110 et l'électrode secondaire 402 forment ainsi un condensateur de capacité $C_l$.

De manière non limitative, l'électrode secondaire 402 est plus petite que l'électrode principale 110. Dans cet exemple, l'axe d'élongation 406 de l'électrode secondaire 402 est inférieur à l'axe d'élongation 118 de l'électrode principale 110.

Le commutateur électrique 404 est agencé pour :

- connecter, dans une première position, le moyen de mesure 112 à l'électrode principale 110, notamment connecter le condensateur 302 du moyen de mesure 112 à la l'électrode principale 110, et
- connecter, dans une deuxième position, le moyen de mesure 112 à l'électrode secondaire 402, notamment connecter le condensateur 302 du moyen de mesure 112 à l'électrode secondaire 402.

Dans cet exemple le commutateur électrique 404 est positionné au niveau du premier point de connexion 306. En outre, le commutateur électrique 404 illustré en FIGURE 4A est dans la première position, c'est-à-dire qu'il connecte le moyen de mesure 112 à l'électrode principale 110.

Lorsque le commutateur électrique est dans la première position, alors le moyen de mesure 112 mesure une tension notée $V_{M1}(t)$ et fonction de la tension du câble 102 notée $V_X(t)$. En particulier, le moyen de mesure 112 fournit la tension $V_{M1}(t)$ se formulant suivant la formule Math 3.

A titre d'exemple non limitatif, l'unité de traitement 202 du dispositif 400 est positionnée dans le volume intérieur 108 de l'enveloppe 104.

A titre d'exemple non limitatif, L'électrode principale 110 peut consister en la face avant d'un circuit imprimé. La seconde électrode 402 peut être constituée d'une bande de cuivre positionnée sur la face arrière du circuit imprimé comprenant sur sa face avant l'électrode principale 110.

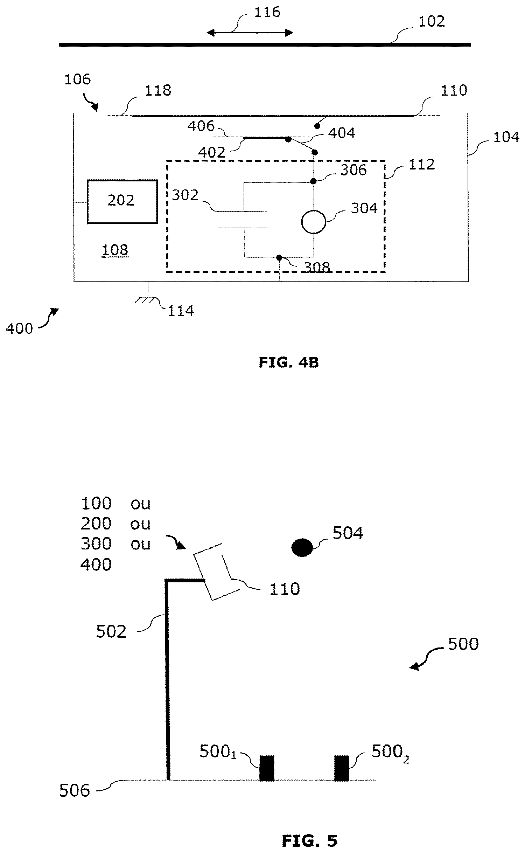

La FIGURE 4B est une deuxième représentation schématique d'un exemple de réalisation non limitatif du dispositif 400 .

Le dispositif 400 illustré en FIGURE 4B comprend toutes les éléments du dispositif 400 illustré en FIGURE 4A. Dans cet exemple, le commutateur électrique 404 est dans la deuxième position. Le commutateur électrique 404 connecte l'électrode secondaire 402 au moyen de mesure 112.

Lorsque le commutateur électrique 404 est dans la deuxième position, alors moyen de mesure 112 mesure une tension notée $V_{M2}(t)$ fonction de la tension du câble 102 notée $V_X(t)$. En particulier, le moyen de mesure 112 fournit la tension $V_{M2}(t)$ se formulant suivant la formule Math 4.

Ainsi, en mesurant la tension $V_{M1}(t)$ délivrée par le moyen de mesure 112 lorsque le commutateur électrique 404 est dans la première position (i.e. lorsque le commutateur électrique 404 relie la première électrode 110 au condensateur 302), puis la tension $V_{M2}(t)$ délivrée par le moyen de mesure 112 lorsque le commutateur électrique 404 est dans la deuxième position (i.e. lorsque le commutateur électrique 404 relie l'électrode secondaire 402 au condensateur 302), on aboutit à un système à deux équations défini par les formules Math 3 et Math 4 avec la capacité notée $C_{eq}$ représentant la valeur de capacité équivalente à la mise en série des condensateurs de valeur $C_X$ et La capacité équivalente est déterminée par la formule Math 5. La résolution des équations Math 3 et Math 4 à au moins une inconnue permet de remonter à la tension $V_x(t)$ du câble 102 suivant la formule Math 2.

Dans cet exemple, la valeur de la capacité $C_I$ est choisie préférentiellement de sorte que la tension $V_{M2}(t)$ soit comprise entre 20 % et 80 % de la valeur de $V_{M1}(t)$. La capacité inconnue Cx est déterminé au moyen de formules simplifiées ou à partir d'une simulation électromagnétique d'une configuration expérimentale de mesure de la tension du câble 102. La formule Math 5 est obtenue après avoir négligé la capacité parasite $C_P$ entre le câble 102 et l'électrode secondaire 402 devant les valeurs des capacités Cx et $C_I$ grâce à la distance d, c'est-à-dire l'espace minimal entre le pourtour de l'électrode principale 110 et l'enveloppe 104. La capacité parasite $C_P$ est ainsi négligeable devant les capacités Cx et $C_I$. Dans ce cas, l'unité de traitement 202 peut déterminer la tension du câble 102 par la formule Math 2.

L'avantage de la conception du dispositif 400 permet une mise en série des capacités Cx (capacité créée entre l'électrode principale 110 et le câble 102) et $C_I$ (capacité créée entre l'électrode principale 110 et l'électrode secondaire 402). Ainsi, seule la capacité $C_I$ peut être connue. En outre, suivant cette conception, encore un seul diviseur capacitif est utilisé pour remonter à la tension du câble 102. Par conséquent, la mesure de tension est simplifiée et plus précise car les erreurs sont limitées. En outre, le dispositif 400 utilise toujours un seul moyen de mesure 112, l'encombrement du dispositif 400 est donc amélioré comparé à des dispositifs de l'état de l'art. En outre, le dispositif 400 n'est soumis à aucune problématique de centrage du câble 102. Le dispositif 400 permet ainsi la mesure sans contact de tension de câble isolé ou de câble non isolé.

Dans les exemples décrits, le dispositif est utilisé pour mesurer une tension alternative. Bien entendu, le dispositif selon l'invention n'est pas limité à la mesure d'une tension alternative et peut être utilisé pour mesure d'une tension continue.

Dans le cas d'une tension continue (DC) appliquée au câble (102), les tensions des électrodes principale (110) et secondaire (402) du dispositif 100, 200, 300, ou 400 seront stationnaires d'où l'impossibilité d'utiliser le moyen de mesure (112) pour déterminer la tension inconnue Vx(t) via les relations Math 1 ou Math 2, ces relations nécessitant des signaux variables (AC) pour qu'un pont diviseur capacitif fonctionne.

Néanmoins, le dispositif 100, 200, 300 ou 400 peut permettre de déterminer la valeur d'une tension continue appliquée au câble (102) grâce aux harmoniques générées lors de la conversion d'énergie AC-DC ou DC-DC utilisée pour alimenter le câble (102). A titre d'exemple, la transformation AC-DC par redressement par diodes génère des harmoniques à la fréquence du signal AC redressé, l'amplitude de la tension de ces harmoniques présents sur le signal DC à mesurer étant directement proportionnelle à l'amplitude dudit signal DC à mesurer. Ainsi, par mesure des harmoniques ou transitoires générées par la conversion d'énergie AC-DC ou DC-DC utilisée pour alimenter le câble (102), la tension DC du câble (102) peut être indirectement mesurée.

Dans le cas où l'amplitude des signaux parasites issus de la conversion d'énergie AC-DC ou DC-DC ne sont pas directement proportionnels à la tension DC du câble (102) ou dans le cas où l'amplitude de ces signaux parasites est trop faible pour permettre une mesure précise de ladite tension DC du câble (102), la tension DC peut être mesurée par mise en mouvement oscillant soit de l'électrode secondaire (402), soit de l'électrode principale (110), soit de l'intégralité du dispositif 100, 200, 300, ou 400. En effet, par mise en mouvement oscillant à une fréquence fosc, on réalise une transposition de fréquence entre le DC (fréquence nulle) et la fréquence d'oscillation fosc permettant ainsi d'utiliser le principe de pont diviseur mise en œuvre par le dispositif selon l'invention grâce aux relations Math 1 et/ou Math 2. Le mouvement oscillant sera de préférence effectuée selon une direction perpendiculaire à la direction d'élongation du câble (102) et qui relie le câble (102) au dispositif 100, 200, 300 ou 400. Cette mise en mouvement peut être réalisée au moyen de tout dispositif mécanique, électrique, pneumatique permettant de mettre en oscillation une masse quelconque. De manière préférentielle, on fera osciller uniquement l'électrode secondaire (402) car elle peut être de très petite dimension et par conséquent très légère : sa mise en mouvement pourra être réalisée au moyen d'un vibreur mécanique du type de ceux présent dans les smartphones ou d'un actionneur piézoélectrique.

La FIGURE 5 est un représentation schématique d'un premier exemple d'une voie ferrée 500 équipée d'un dispositif 100, 200, 300 ou 400 .

La voie ferrée 500 est une voie ferrée monovoie 500. La voie ferrée 500 comprend deux rails $500_1$ et $500_2$ agencés pour servir à la circulation ou l'arrêt d'un véhicule ferroviaire.

Le dispositif 100, 200, 300 ou 400 est positionné en hauteur sur un poteau 502 qui est relié à la terre. Le poteau 502 est positionné à proximité de la voie ferrée 500 sur un sol 506.

Une caténaire 504 est illustrée en FIGURE 5. La caténaire 504 est agencée pour alimenter au moins un véhicule ferroviaire circulant sur la voie ferrée 500. Ainsi, le dispositif est agencé pour mesurer une tension de la caténaire 504.

Le dispositif 100, 200, 300 ou 400 peut être mobile ou stationnaire.

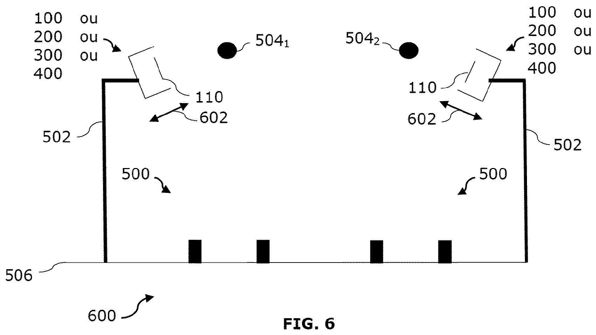

La FIGURE 6 est un représentation schématique d'un deuxième exemple d'une voie ferrée 600 équipée d'un dispositif 100, 200, 300 ou 400.

La voie ferrée 600 est une voie ferrée comprenant deux voies 500. Chaque voie 500 de la voie ferrée 600 comprend deux rails agencés pour servir à la circulation ou l'arrêt d'un véhicule ferroviaire. Deux caténaires $504_1$, $504_2$ sont illustrées en FIGURE 6. Chaque caténaire 504 de la FIGURE 6 est agencée pour alimenter au moins un véhicule ferroviaire (non illustré) circulant sur la voie ferrée 600 ou étant en arrêt sur la voie ferrée 600.

Un poteau 502 est positionné à proximité de chaque voie ferrée 500 illustrée en FIGURE 6. Chaque poteau 502 comprend un dispositif 100, 200, 300 ou 400 positionné en hauteur et à proximité d'une caténaire 504. Les deux dispositifs 100, 200, 300 ou 400 selon l'invention illustrés en FIGURE 6 peuvent être similaires ou différents.

Les dispositifs 100, 200, 300 ou 400 peuvent être mobiles ou stationnaires. A titre d'exemple non limitatif, chaque dispositif 100, 200, 300 ou 400 peut être relié au poteau 502 par une liaison pivot ou de préférence par une liaison sphérique. Le mouvement du dispositif peut ainsi être angulaire, suivant au moins un degré, de préférence trois degrés de liberté.

A titre d'exemple non limitatif, sur la voie 500 de gauche de la caténaire $504_1$, le moyen de mesure 112 du dispositif 100, 200, 300 ou 400 est agencé pour mesurer une tension $V_{M1G}(t)$. Sur la voie 500 de droite, le moyen de mesure 112 du dispositif 100, 200, 300 ou 400 est agencé pour mesurer une tension $V_{M2D}(t)$. Les équations de Maxwell dépendent des valeurs des capacités inconnues Cx relatives au caténaire linéaire $504_1$, positionné à gauche, et au caténaire linéaire $504_2$, positionné à droite. Dans cet exemple et par application des équations de Maxwell, le moyen de mesure 112 du dispositif positionné le long de la voie 500 de gauche est agencé pour mesurer une tension $V_{M1G}(t)$ définie par la formule :

$$V_{M1G}(t) = \alpha_G \, V_{504_1}(t) + \beta_G \, V_{504_2}(t)$$

avec

- $V_{504_1}(t)$ correspondant à la tension inconnue de la caténaire $504_1$ positionnée sur la voie de gauche,
- $V_{504_2}(t)$ correspondant à la tension inconnue de la caténaire $504_2$ positionnée sur la voie de droite, et
- $\alpha_G$ et $\beta_G$ correspondant à des paramètres de la relation linéaire reliant la tension mesurée $V_{M1G}(t)$ aux tensions inconnues des caténaires de gauche $V_{504_1}(t)$ et de droite $V_{S04_2}(t)$.

Le moyen de mesure 112 du dispositif positionné le long de la voie 500 de droite est agencé pour mesurer une tension $V_{M1D}(t)$ définie par la formule :

$$V_{M2D}(t) = \alpha_D \, V_{504_2}(t) + \beta_D \, V_{504_1}(t)$$

avec

- $V_{504_1}(t)$ correspondant à la tension inconnue de la caténaire 501 positionnée sur la voie de gauche,
- $V_{504_2}(t)$ correspondant à la tension inconnue de la caténaire 501 positionnée sur la voie de droite, et
- $\alpha_D$ et $\beta_D$ correspondant à des paramètres de la relation linéaire reliant la tension mesurée $V_{M2D}(t)$ aux tensions inconnues des caténaires de gauche $V_{5041}(t)$ et de droite $V_{5041}(t)$.

Dans cet exemple, la caténaire 504 positionnée sur la voie adjacente sur laquelle la mesure est réalisée intervient dans la mesure de la tension de la caténaire. Les coefficient $\beta_G$ et $\beta_D$ ne sont donc pas nuls. En outre, les valeurs $\alpha_G$ et $\alpha_D$ peuvent être égales ou de mêmes grandeurs et sont chacune de préférence supérieures d'un facteur 4 aux valeurs des coefficients $\beta_G$ et $\beta_D$.

De manière non limitative, les paramètres $\alpha_G$, $a_D$, $\beta_G$ et $\beta_D$ peuvent être déterminés en réalisant des étalonnages. A titre d'exemple, un étalonnage peut consister à couper l'alimentation de la caténaire 504 adjacente à celle sur laquelle un dispositif 100, 200, 300, 400 réalise la mesure de tension d'une caténaire de manière à mesurer uniquement la tension d'intérêt. Par exemple pour une mesure de la tension de la caténaire $504_1$, cela revient à couper l'alimentation de la caténaire $504_2$ de manière à déterminer les paramètre $\alpha_G$ et $\beta_D$ et ensuite de couper l'alimentation de la caténaire $504_1$ de manière à déterminer les paramètre $\beta_G$ et $\alpha_D$. Cet exemple peut aussi être appliqué à une mesure de tension d'une ligne aérienne de transport d'énergie triphasée ou à un système pour mesurer une multitude de tension de câble.

Dans une autre variante non limitative, il peut être impossible de réaliser un étalonnage tel que décrit dans le précédent exemple. Dans ce cas, les dispositifs 100, 200, 300, 400 peuvent chacun être déplacé suivant une direction 602. Le déplacement des dispositifs 100, 200, 300 ou 400 suivant la direction 602 permet de faire varier les paramètres $\alpha_D$, $\alpha_G$, $\beta_D$, $\beta_G$. Les paramètres $\alpha_D$, $\alpha_G$, $\beta_D$, $\beta_G$ peuvent augmenter ou diminuer. Par exemple, pour la voie de gauche (côté de la caténaire $504_1$), le déplacement du dispositif 100, 200, 300 ou 400 peut faire varier à la hausse ou à la baisse les paramètres $\alpha_G$ et $\beta_G$. En outre, pour une position du dispositif 100, 200, 300 ou 400 suivant la direction 602, le paramètre $\beta_G$ peut être constant et pour une autre position du dispositif 100, 200, 300 ou 400 dans la direction 602, le paramètre $\alpha_G$ est invariant. De cette manière, en faisant osciller le dispositif 100, 200, 300 ou 400 selon une position pour laquelle le paramètre $\beta_G$ est constant, des variations de tension mesurée par le dispositif 100, 200, 300 ou 400 sont obtenues à une fréquence d'oscillation qui dépend seulement de la tension de la caténaire $504_1$ et non de la caténaire $504_2$ positionnée à proximité de la caténaire $504_1$ sur laquelle la mesure est réalisée.

Bien entendu, l'invention n'est pas limitée aux exemples qui viennent d'être décrits. De nombreuses modifications peuvent être apportées à ces exemples sans sortir du cadre de la présente invention telle que décrite dans les revendications annexées.

**Revendications**

1. Système pour la mesure sans contact de tension d'une caténaire (504 ;$504_1$,$504_2$) d'une voie ferrée (500), par rapport à un potentiel de référence (114), ledit système comprenant au moins un dispositif (100;200;300;400) pour la mesure sans contact d'une tension de ladite caténaire ((504 ;$504_1$,$504_2$)), ledit dispositif (100, 200, 300, 400) comprenant :

   - un poteau (502) relié à la terre, ledit poteau (502) étant configuré pour être positionné le long de ladite voie ferrée (500), de préférence le long d'une lame de ladite voie ferrée (500);

      - une enveloppe (104), configurée pour être connectée au potentiel de référence, (114) comprenant :

         - une ouverture (106) configurée pour être orientée vers ladite caténaire (504 ;$504_1$,$504_2$),
         - un volume intérieur (108) comprenant :

            ▪ une électrode (110), appelée électrode principale (110), positionnée au niveau de l'ouverture (106) et configurée à être positionnée au regard de ladite caténaire (504 ;$504_1$,$504_2$),
            ▪ un moyen de mesure (112) agencé pour mesurer une tension entre l'électrode principale (110) et ladite enveloppe (104) ;

         - une unité de traitement (202) agencée et/ou programmée pour mesurer la tension de ladite caténaire (504 ;$504_1$,$504_2$) à partir de la mesure de tension du moyen de mesure (112), d'une capacité créée par l'électrode principale (110) et ladite caténaire (504 ;$504_1$,$504_2$) et d'une capacité issue du moyen de mesure (112) ;

   ledit dispositif (100;200;300;400) étant positionné sur ledit poteau (502) ledit dispositif (100;200;300;400) étant configuré pour être à une position non nulle du sol (506),

2. Système selon la revendication 1, **caractérisé en ce que** le moyen de mesure (112) comprend un condensateur (302) et un capteur de tension (304) agencé pour mesurer une tension aux bornes du condensateur (302).

3. Système selon l'une quelconque des revendications précédentes, **caractérisé en ce que** l'électrode principale (110) est couplée de manière capacitive à la caténaire (504 ;504$_1$,504$_2$) et **en ce que** ledit dispositif (100,200,300,400) est dénué de contact galvanique avec ladite caténaire (504 ;504$_1$,504$_2$).

4. Système selon l'une quelconque des revendications précédentes, **caractérisé en ce que** la caténaire (504 ;504$_1$,504$_2$) s'étend suivant une direction d'élongation (116), l'électrode principale (110) comprend un axe d'élongation (118) parallèle à la direction d'élongation (116) de ladite caténaire (504 ;504$_1$,504$_2$).

5. Système selon l'une quelconque des revendications précédentes, **caractérisé en ce que** l'électrode principale (110) comprend un pourtour positionné à une distance d non nulle de ladite enveloppe (104).

6. Système selon la revendication précédente, **caractérisé en ce que** la tension de la caténaire (504 ;504$_1$,504$_2$) mesurée par l'unité de traitement (202) est déterminée par la formule suivante :

$$V_X(t) = V_M(t) . \left( \frac{C_D + C_X}{C_X} \right)$$

avec

- V$_x$(t) la tension au cours du temps de ladite caténaire (504 ;504$_1$,504$_2$) à déterminer,
- V$_M$(T) la tension mesurée par le moyen de mesure (112) au cours du temps,
- C$_D$ la capacité du moyen de mesure (112),
- Cx la capacité créée par la caténaire (504 ;504$_1$,504$_2$) et l'électrode principale (110).

7. Système selon l'une quelconque des revendications précédentes, **caractérisé en ce que** le dispositif comprend une autre électrode (402), appelée électrode secondaire (402), positionnée au regard de l'électrode principale (110).

8. Système selon la revendication précédente, **caractérisé en ce que** l'électrode secondaire (402) est en outre positionnée au regard du moyen de mesure (112).

9. Système selon l'une quelconque des revendications 7 ou 8, **caractérisé en ce que** l'électrode secondaire (402) comprend un axe d'élongation (406) parallèle à l'électrode principale (110).

10. Système selon l'une quelconque des revendications 7 à 9, **caractérisé en ce que** l'électrode secondaire (302) est inférieure en taille à l'électrode principale (110).

11. Système selon l'une quelconque des revendications 7 à 10, caractérisé en que le dispositif (400) comprend un commutateur électrique (404) agencé pour :

- connecter, dans une première position, le moyen de mesure (112) à l'électrode principale (110), et
- connecter, dans une deuxième position, le moyen de mesure (112) à l'électrode secondaire (402).

12. Système selon l'une quelconque des revendications 7 à 11 considéré comme dépendant de la revendication 6, **caractérisé en ce que** l'unité de traitement (202) est en outre agencée et/ou programmée pour mesurer la tension de la caténaire (504;504$_1$,504$_2$) en fonction d'une capacité créée par l'électrode principale (110) et l'électrode secondaire (402).

13. Système selon les revendications 11 et 6, **caractérisé en ce que** la tension de la caténaire (504;504$_1$,504$_2$) mesurée par l'unité de traitement (202) est déterminée par la formule suivante :

$$V_X(t) = \frac{\left( \frac{C_D}{C_I} \right) . V_{M1}(t)}{\left( \left( \frac{V_{M1}(t)}{V_{M2}(t)} \right) - 1 \right)}$$

avec

- $V_{M1}(t)$ correspondant à la tension mesurée par le moyen de mesure (112) lorsque le commutateur (404) est dans la première position,
- $V_{M2}(t)$ correspondant à la tension mesurée par le moyen de mesure (112) lorsque le commutateur (404) est dans la deuxième position,
- $C_D$ étant la capacité du moyen de mesure (112), et
- $C_I$ étant la capacité créée par l'électrode principale (110) et secondaire (402).

**14.** Système selon la revendication précédente, **caractérisé en ce que**,

- lorsque le commutateur (404) est dans la première position, la tension mesurée par le moyen de mesure (112) est définie par la formule suivante

$$V_{M1}(t) = V_X(t) \cdot \left(\frac{C_X}{(C_D + C_X)}\right),$$

et
- lorsque le commutateur (404) est dans la deuxième position, la tension mesurée par le moyen de mesure (112) est définie par la formule suivante

$$V_{M2}(t) = V_X(t) \cdot \left(\frac{C_{eq}}{(C_{eq} + C_D)}\right)$$

avec
- $C_D$ étant la capacité du moyen de mesure (112),
- $C_X$ étant la capacité créée par la caténaire (504;$504_1$,$504_2$) et l'électrode principale (110),
- $C_I$ étant la capacité créée par l'électrode principale (110) et secondaire (402), et
- $C_{eq}$ représentant une capacité équivalente d'une mise en série de la capacité créée par l'électrode principale (110) et l'électrode secondaire (402) et de la capacité créée par la caténaire (504 ;$504_1$,$504_2$) et l'électrode principale (110).

**15.** Système selon la revendication précédente, **caractérisé en ce que** la capacité équivalente mesurée par l'unité de traitement (202) est déterminée par la formule :

$$C_{eq} = \frac{C_X \cdot C_I}{(C_X + C_I)}$$

avec

- Cx étant la capacité créée par le câble (102) et l'électrode principale (110), et
- $C_I$ étant la capacité créée par l'électrode principale (110) et secondaire (402).

**16.** Système selon l'une quelconque des revendications précédentes, pour la mesure sans contact de tension d'au moins deux caténaires ($504_1$, $504_2$) d'une double voies ferrées (600), ledit système comprenant au moins deux dispositifs, chaque dispositif (100;200;300;400) étant positionné sur un poteau (502) relié à la terre, chaque dispositif (100;200;300;400) étant à une position non nulle du sol (506), chaque poteau (502) étant positionné le long d'une des voies ferrées (500), de préférence le long d'une des lames d'une desdites voies ferrées (500).

**17.** Système selon l'une quelconque des revendications précédentes, **caractérisé en ce que** le, ou chaque, dispositif (100;200;300;400) est agencé sur le poteau (502) de manière mobile.

**18.** Voie ferrée (500;600) comportant un système selon l'une quelconque des revendications précédentes, pour mesurer une tension d'au moins une caténaire.

**19.** Voie ferrée (600) selon la revendication précédente, **caractérisé en ce qu'**elle comprend :

- deux voies adjacentes, à savoir une voie de gauche et une voie de droite, chaque voie comprenant une caténaire,
- pour chacune desdites voies, un dispositif pour mesurer une tension de la caténaire de ladite voie ;

et **en ce que**

- le moyen de mesure (112) du dispositif de la voie de gauche est agencé pour mesurer une tension $V_{MG}(t)$ définie par la formule suivante :

$$V_{MG}(t) = \alpha_G \, V_{CG}(t) + \beta_G \, V_{CD}(t) \text{ (Math 6)}$$

- le moyen de mesure (112) du dispositif de la voie de droite est agencé pour mesurer une tension $V_{MD}(t)$ définie par la formule suivante :

$$V_{MD}(t) = \alpha_D \, V_{CD}(t) + \beta_D \, V_{CG}(t) \text{ (Math 7)}$$

avec
- $V_{CG}(t)$ correspondant à la tension inconnue de la caténaire $504_1$ positionnée sur la voie de gauche,
- $V_{CD}(t)$ correspondant à la tension inconnue de la caténaire $504_2$ positionnée sur la voie de droite, et
- $\alpha_G$, $\alpha_D$, $\beta_G$ et $\beta_D$ correspondant à des paramètres de la relation linéaire reliant les tensions mesurées $V_{MG}(t)$ et $V_{MD}(t)$ aux tensions inconnues des caténaires gauche $V_{CG}(t)$ et droite $V_{CD}(t)$.

**Patentansprüche**

1. System für die kontaktlose Spannungsmessung einer Oberleitung (504; $504_1$, $504_2$) eines Gleisstrangs (500) relativ zu einem Referenzpotential (114), das System umfassend mindestens eine Vorrichtung (100; 200; 300; 400) für die kontaktlose Messung einer Spannung der Oberleitung ((504; $504_1$, $504_2$)), die Vorrichtung (100, 200, 300, 400) umfassend:

   - einen Mast (502), der mit der Erde verbunden ist, wobei der Mast (502) konfiguriert ist, um entlang des Gleisstrangs (500), vorzugsweise entlang einer Zunge des Gleisstrangs (500), positioniert zu werden;

     - ein Gehäuse (104), das konfiguriert ist, um an das Referenzpotential (114) angeschlossen zu werden, umfassend:
     - eine Öffnung (106), die konfiguriert ist, um auf die Oberleitung (504; $504_1$, $504_2$) ausgerichtet zu sein,
     - ein Innenvolumen (108), umfassend:

       ▪ eine Elektrode (110), genannt Hauptelektrode (110), die an der Öffnung (106) positioniert und konfiguriert ist, um gegenüber der Oberleitung (504; $504_1$, $504_2$) positioniert zu werden,
       ▪ ein Messmittel (112), das zum Messen einer Spannung zwischen der Hauptelektrode (110) und dem Gehäuse (104) angeordnet ist;

     - eine Verarbeitungseinheit (202), die zum Messen der Spannung der Oberleitung (504; $504_1$, $504_2$) aus der Spannungsmessung des Messmittels (112), einer Kapazität, die durch die Hauptelektrode (110) und die Oberleitung (504; $504_1$, $504_2$) erzeugt wird, und einer Kapazität angeordnet und/oder programmiert ist, die von dem Messmittel (112) stammt;

   wobei die Vorrichtung (100; 200; 300; 400) auf dem Mast (502) positioniert ist;
   die Vorrichtung (100; 200; 300; 400) konfiguriert ist, um an einer von null verschiedenen Position von dem Boden (506) zu sein.

2. System nach Anspruch 1, **dadurch gekennzeichnet, dass** das Messmittel (112) einen Kondensator (302) und einen Spannungssensor (304) umfasst, der zum Messen einer Spannung an den Anschlussklemmen des Kondensators (302) angeordnet ist.

3. System nach einem der vorstehenden Ansprüche, **dadurch gekennzeichnet, dass** die Hauptelektrode (110) auf kapazitive Weise an die Oberleitung (504; $504_1$, $504_2$) gekoppelt ist, und dadurch, dass die Vorrichtung (100, 200, 300, 400) ohne einen galvanischen Kontakt mit der Oberleitung (504; $504_1$, $504_2$) ist.

4. System nach einem der vorstehenden Ansprüche, **dadurch gekennzeichnet, dass** sich die Oberleitung (504; $504_1$, $504_2$) entlang einer Ausdehnungsrichtung (116) erstreckt, die Hauptelektrode (110) eine Ausdehnungsachse (118) umfasst, die parallel zu der Ausdehnungsrichtung (116) der Oberleitung (504; $504_1$, $504_2$) verläuft.

5. System nach einem der vorstehenden Ansprüche, **dadurch gekennzeichnet, dass** die Hauptelektrode (110) einen Umfang umfasst, der in einem von null verschiedenen Abstand d von dem Gehäuse (104) positioniert ist.

6. System nach dem vorstehenden Anspruch, **dadurch gekennzeichnet, dass** die Spannung der Oberleitung (504; $504_1$, $504_2$), die durch die Verarbeitungseinheit (202) gemessen wird, durch folgende Formel bestimmt wird:

$$V_X(t) = V_M(t) \cdot \left( \frac{C_D + C_X}{C_X} \right)$$

wobei

- $V_x(t)$ die zu bestimmende Spannung über die Zeit der Oberleitung (504; $504_1$, $504_2$),
- $V_M(T)$ die Spannung, die durch das Messmittel (112) gemessen wird, über die Zeit,
- $C_D$ die Kapazität des Messmittels (112),
- $C_x$ die Kapazität, die durch die Oberleitung (504; $504_1$, $504_2$) und die Hauptelektrode (110) erzeugt wird.

7. System nach einem der vorstehenden Ansprüche, **dadurch gekennzeichnet, dass** die Vorrichtung eine weitere Elektrode (402) umfasst, genannt Sekundärelektrode (402), die gegenüber der Hauptelektrode (110) positioniert ist.

8. System nach dem vorstehenden Anspruch, **dadurch gekennzeichnet, dass** die Sekundärelektrode (402) ferner gegenüber des Messmittels (112) positioniert ist.

9. System nach einem der Ansprüche 7 oder 8, **dadurch gekennzeichnet, dass** die Sekundärelektrode (402) eine Ausdehnungsachse (406) umfasst, die parallel zu der Hauptelektrode (110) verläuft.

10. System nach einem der Ansprüche 7 bis 9, **dadurch gekennzeichnet, dass** die Sekundärelektrode (302) kleiner als die Hauptelektrode (110) ist.

11. System nach einem der Ansprüche 7 bis 10, **dadurch gekennzeichnet, dass** die Vorrichtung (400) einen elektrischen Schalter (404) umfasst, der angeordnet ist zum:

- Anschließen, in einer ersten Position, des Messmittels (112) an die Hauptelektrode (110), und
- Anschließen, in einer zweiten Position, des Messmittels (112) an die Sekundärelektrode (402).

12. System nach einem der Ansprüche 7 bis 11, der als von Anspruch 6 abhängig angesehen wird, **dadurch gekennzeichnet, dass** die Verarbeitungseinheit (202) ferner zum Messen der Spannung der Oberleitung (504; $504_1$, $504_2$) in Abhängigkeit von einer Kapazität angeordnet und/oder programmiert ist, die durch die Hauptelektrode (110) und die Sekundärelektrode (402) erzeugt wird.

13. System nach Anspruch 11 und 6, **dadurch gekennzeichnet, dass** die Spannung der Oberleitung (504; $504_1$, $504_2$), die durch die Verarbeitungseinheit (202) gemessen wird, durch die folgende Formel bestimmt wird:

$$V_X(t) = \frac{\left( \frac{C_D}{C_I} \right) \cdot V_{M1}(t)}{\left( \left( \frac{V_{M1}(t)}{V_{M2}(t)} \right) - 1 \right)}$$

wobei

- $V_{M1}(t)$ der Spannung entspricht, die durch das Messmittel (112) gemessen wird, wenn sich der Schalter (404) in der ersten Position befindet,
- $V_{M2}(t)$ der Spannung entspricht, die durch das Messmittel (112) gemessen wird, wenn sich der Schalter (404) in der zweiten Position befindet,
- $C_D$ die Kapazität des Messmittels (112) ist, und
- $C_I$ die Kapazität ist, die durch die Hauptelektrode (110) und die Sekundärelektrode (402) erzeugt wird.

**14.** System nach dem vorstehenden Anspruch, **dadurch gekennzeichnet, dass**

- wenn sich der Schalter (404) in der ersten Position befindet, die Spannung, die durch das Messmittel (112) gemessen wird, durch die folgende Formel definiert ist

$$V_{M1}(t) = V_X(t) \cdot \left( \frac{c_X}{(c_D + c_X)} \right),$$

und
- wenn sich der Schalter (404) in der zweiten Position befindet, die Spannung, die durch das Messmittel (112) gemessen wird, durch die folgende Formel definiert ist

$$V_{M2}(t) = V_X(t) \cdot \left( \frac{C_{eq}}{(C_{eq} + C_D)} \right)$$

wobei
- $C_D$ die Kapazität des Messmittels (112) ist,
- $C_X$ die Kapazität ist, die durch die Oberleitung (504; $504_1$, $504_2$) und die Hauptelektrode (110) erzeugt wird,
- $C_I$ die Kapazität ist, die durch die Hauptelektrode (110) und die Sekundärelektrode (402) erzeugt wird, und
- $C_{eq}$ eine äquivalente Kapazität einer Reihenschaltung der Kapazität, die durch die Hauptelektrode (110) und die Sekundärelektrode (402) erzeugt wird, und der Kapazität darstellt, die durch die Oberleitung (504; $504_1$, $504_2$) und die Hauptelektrode (110) erzeugt wird.

**15.** System nach dem vorstehenden Anspruch, **dadurch gekennzeichnet, dass** die äquivalente Kapazität, die durch die Verarbeitungseinheit (202) gemessen wird, durch die folgende Formel bestimmt wird:

$$C_{eq} = \frac{C_X \cdot C_I}{(C_X + C_I)}$$

wobei

- $C_X$ die Kapazität ist, die durch das Kabel (102) und die Hauptelektrode (110) erzeugt wird, und
- $C_I$ die Kapazität ist, die durch die Hauptelektrode (110) und die Sekundärelektrode (402) erzeugt wird.

**16.** System nach einem der vorstehenden Ansprüche für die kontaktlose Spannungsmessung von mindestens zwei Oberleitungen ($504_1$, $504_2$) eines doppelten Gleisstrangs (600), das System umfassend mindestens zwei Vorrichtungen, wobei jede Vorrichtung (100; 200; 300; 400) auf einem Mast (502) positioniert ist, der mit dem Boden verbunden ist, wobei jede Vorrichtung (100; 200; 300; 400) jeweils in einer von null verschiedenen Position von dem Boden (506) ist, wobei jeder Mast (502) entlang eines der Gleisstränge (500) positioniert ist, vorzugsweise entlang einer der Zungen eines der Gleisstränge (500).

**17.** System nach einem der vorstehenden Ansprüche, **dadurch gekennzeichnet, dass** die oder jede Vorrichtung (100; 200; 300; 400) auf dem Mast (502) auf bewegbare Weise angeordnet ist.

**18.** Gleisstrang (500;600), der ein System nach einem der vorstehenden Ansprüche zum Messen einer Spannung mindestens einer Oberleitung aufweist.

**19.** Gleisstrang (600) nach dem vorstehenden Anspruch, **dadurch gekennzeichnet, dass** er umfasst:

- zwei nebeneinanderliegende Gleise, nämlich ein linkes Gleis und ein rechtes Gleis, jedes Gleis umfassend eine Oberleitung,
- für jedes der Gleise eine Vorrichtung zum Messen der Spannung der Oberleitung des jeweiligen Gleises;

und dadurch, dass

- das Messmittel (112) der Vorrichtung des linken Gleises zum Messen einer Spannung $V_{MG}(t)$ angeordnet ist, die durch die folgende Formel definiert ist:

$$V_{MG}(t) = \alpha_G\, V_{CG}(t) + \beta_G\, V_{CD}(t) \quad \text{(Math 6)}$$

- das Messmittel (112) der Vorrichtung des rechten Gleises zum Messen einer Spannung $V_{MD}(t)$ angeordnet ist, die durch die folgende Formel definiert ist:

$$V_{MD}(t) = \alpha_D\, V_{CD}(t) + \beta_D\, V_{CG}(t) \quad \text{(Math 7)}$$

wobei
- $V_{CG}(t)$ der unbekannten Spannung der Oberleitung $504_1$ entspricht, die auf dem linken Gleis positioniert ist,
- $V_{CD}(t)$ der unbekannten Spannung der Oberleitung $504_2$ entspricht, die auf dem rechten Gleis positioniert ist, und
- $\alpha_G$, $\alpha_D$, $\beta_G$ und $\beta_D$ den Parametern der linearen Beziehung entsprechen, die die gemessenen Spannungen $V_{MG}(t)$ und $V_{MD}(t)$ mit den unbekannten Spannungen der linken $V_{CG}(t)$ und der rechten Oberleitung $V_{CD}(t)$ verbindet.

## Claims

1. System for contactless voltage measurement of an overhead catenary ($504;504_1,504_2$) of a railroad track (500) with respect to a reference potential (114), said system comprising at least one device (100;200;300;400) for contactless measurement of a voltage of said overhead catenary (($504;504_1,504_2$)), said device (100, 200, 300, 400) having:

   - an earthed pole (502), said pole (502) being designed to be positioned along said railroad track (500), preferably along a point rail of said railroad track (500);

     - a casing (104) designed to be connected to the reference potential (114), the casing comprising:
     - an opening (106) designed to be oriented toward said overhead catenary ($504;504_1,504_2$),
     - an interior volume (108) comprising:

       ▪ an electrode (110), referred to as the main electrode (110), positioned at opening (106) and designed to be positioned opposite said overhead catenary ($504;504_1,504_2$),
       ▪ a measuring means (112) arranged to measure a voltage between the main electrode (110) and said casing (104);

     - a processing unit (202) arranged and/or programmed to measure the voltage of said overhead catenary ($504;504_1,504_2$) based on the voltage measurement of the measuring means (112), on a capacitance generated by the main electrode (110) and said overhead catenary ($504; 504_1, 504_2$) and on a capacitance from the measuring means (112);

   said device (100;200;300;400) being positioned on said pole (502);
   said device (100;200;300;400) being designed to be at a non-zero position from the ground (506).

2. System according to claim 1, **characterized in that** the measuring means (112) comprises a capacitor (302) and a voltage sensor (304) arranged to measure a voltage at the terminals of the capacitor (302).

3. System according to either of the preceding claims, **characterized in that** the main electrode (110) is capacitively coupled to the overhead catenary ($504; 504_1,504_2$) and **in that** said device (100,200,300,400) is not in galvanic contact with said overhead catenary ($504; 504_1,504_2$).

4. System according to any of the preceding claims, **characterized in that** the overhead catenary (504; $504_1$,$504_2$) extends in an elongation direction (116), the main electrode (110) comprises an elongation axis (118) parallel to the elongation direction (116) of said overhead catenary (504; $504_1$,$504_2$).

5. System according to any of the preceding claims, **characterized in that** the main electrode (110) comprises a boundary positioned at a non-zero distance d from said casing (104).

6. System according to the preceding claim, **characterized in that** the voltage of the overhead catenary (504; $504_1$,$504_2$) measured by the processing unit (202) is determined by means of the following formula:

$$V_X(t) = V_M(t) \cdot (\frac{C_D + C_X}{C_X})$$

where

- $V_X(t)$ is the voltage over time of said overhead catenary (504;5041,5042) to be determined,
- VM(T) is the voltage measured by the measuring means (112) over time,
- CD is the capacitance of the measuring means (112),
- CX is the capacitance generated by the overhead catenary (504;5041,5042) and the main electrode (110).

7. System according to any of the preceding claims, **characterized in that** the device comprises another electrode (402), referred to as the secondary electrode (402), positioned opposite the main electrode (110).

8. System according to the preceding claim, **characterized in that** the secondary electrode (402) is further positioned opposite the measuring means (112).

9. System according to either of claims 7 or 8, **characterized in that** the secondary electrode (402) comprises an elongation axis (406) parallel to the main electrode (110).

10. System according to any of claims 7 to 9, **characterized in that** the secondary electrode (302) is smaller in size than the main electrode (110).

11. System according to any of claims 7 to 10, **characterized in that** the device (400) comprises an electric switch (404) arranged to:

- connect, in a first position, the measuring means (112) to the main electrode (110), and
- connect, in a second position, the measuring means (112) to the secondary electrode (402).

12. System according to any of claims 7 to 11 when dependent on claim 6, **characterized in that** the processing unit (202) is further arranged and/or programmed to measure the voltage of the overhead catenary (504;$504_1$,$504_2$) according to a capacitance generated by the main electrode (110) and the secondary electrode (402).

13. System according to claims 11 and 6, **characterized in that** the voltage of the overhead catenary (504;$504_1$,$504_2$) measured by the processing unit (202) is determined by means of the following formula:

$$V_X(t) = \frac{(\frac{C_D}{C_I}) \cdot V_{M1}(t)}{(\left(\frac{V_{M1}(t)}{V_{M2}(t)}\right) - 1)}$$

where

- $V_{M1}(t)$ corresponds to the voltage measured by the measuring means (112) when the switch (404) is in the first position,
- VM2(t) corresponds to the voltage measured by the measuring means (112) when the switch (404) is in the second position,

- CD is the capacitance of the measuring means (112), and
- Cl is the capacitance generated by the main electrode (110) and the secondary electrode (402).

14. System according to the preceding claim, **characterized in that**

- when the switch (404) is in the first position, the voltage measured by the measuring means (112) is defined by means of the following formula

$$V_{M1}(t) = V_X(t) \cdot \left(\frac{C_X}{C_D + C_X}\right)$$

and
- when the switch (404) is in the second position, the voltage measured by the measuring means (112) is defined by means of the following formula

$$V_{M2}(t) = V_X(t) \cdot \left(\frac{C_{eq}}{C_{eq} + C_D}\right)$$

where
- $C_D$ is the capacitance of the measuring means (112),
- CX is the capacitance generated by the overhead catenary (504;5041,5042) and the main electrode (110),
- Cl is the capacitance generated by the main electrode (110) and the secondary electrode (402), and
- Ceq represents an equivalent capacitance of a series connection of the capacitance generated by the main electrode (110) and the secondary electrode (402) and of the capacitance generated by the overhead catenary (504;5041,5042) and the main electrode (110).

15. System according to the preceding claim, **characterized in that** the equivalent capacitance measured by the processing unit (202) is determined by means of the formula:

$$C_{eq} = \frac{C_X \cdot C_I}{(C_X + C_I)}$$

where

- $C_X$ is the capacitance generated by the cable (102) and the main electrode (110), and
- Cl is the capacitance generated by the main electrode (110) and the secondary electrode (402).

16. System according to any of the preceding claims, for contactless voltage measurement of at least two overhead catenaries ($504_1$, $504_2$) of a double railroad track (600), said system comprising at least two devices, each device (100;200;300;400) being positioned on an earthed pole (502), each device (100;200;300;400) being at a non-zero position from the ground (506), each pole (502) being positioned along one of the railroad tracks (500), preferably along one of the point rails of one of said railroad tracks (500).

17. System according to any of the preceding claims, **characterized in that** the, or each, device (100;200;300;400) is movably arranged on the pole (502).

18. Railroad track (500;600) comprising a system according to any of the preceding claims, for measuring a voltage of at least one overhead catenary.

19. Railroad track (600) according to the preceding claim, **characterized in that** it comprises:

- two adjacent tracks, i.e. a left track and a right track, each track having an overhead catenary,
- for each of said tracks, a device for measuring a voltage of the overhead catenary of said track;

and **in that**

- the measuring means (112) of the device of the left track is arranged to measure a voltage $V_{MG}(t)$ defined by means of the following formula:

$$V_{MG}(t) = \alpha_G V_{CG}(t) + \beta_G V_{CD}(t) \text{ (Math 6)}$$

- the measuring means (112) of the device of the right track is arranged to measure a voltage $V_{MD}(t)$ defined by means of the following formula:

$$V_{MD}(t) = \alpha_D V_{CD}(t) + \beta_D V_{CG}(t) \text{ (Math 7)}$$

where
- $V_{CG}(t)$ corresponds to an unknown voltage of the overhead catenary 5041 positioned on the left track,
- VCD(t) corresponds to an unknown voltage of the overhead catenary 5042 positioned on the right track, and
- $\alpha$G, $\alpha$D, $\beta$G and $\beta$D correspond to parameters of the linear relationship linking the measured voltages $V_{MG}(t)$ and $V_{MD}(t)$ to the unknown voltages of the left $V_{CG}(t)$ and right $V_{CD}(t)$ overhead catenaries.

**FIG. 1**

**FIG. 2**

**FIG. 3**

**FIG. 4A**

**FIG. 4B**

**FIG. 5**

100 ou
200 ou
300 ou
400

100 ou
200 ou
300 ou
400

504₁

504₂

110

110

602

602

502

502

500

500

506

600

FIG. 6

**RÉFÉRENCES CITÉES DANS LA DESCRIPTION**

**Documents brevets cités dans la description**

- EP 3321696 A1

- FR 3110704 A